# EUROPEAN PATENT APPLICATION

(11) **EP 3 076 230 A1**
(43) Date of publication of application: **05.10.2016**
(21) Application number: 16160706.4
(22) Date of filing: 16.03.2016
(51) Int. Cl.: G02F 1/1333, F21V 8/00, G02B 6/00

(54) **COOLING SYSTEM OF A DISPLAY**

(30) Priority: 31.03.2015 KR 20150045589
(71) Applicant: Samsung Electronics Co., Ltd., Gyeonggi-do 16677 (KR)
(72) Inventor: PYO, Jin Soo, Seoul (KR); KIM, Jung Kyun, Gyeonggi-do (KR); CHO, Jin Hyun, Seoul (KR)
(74) Representative: Appleyard Lees IP LLP

(57) **Abstract**

Display devices suffer gradual deterioration due to heating effects. This heating is due to the light sources of the backlight, the driver electronics or the sun in the case of outdoor displays. Conventional cooling schemes for displays involving a fan and air-filter are costly to maintain and repair as well as being thick and aesthetically unattractive. In the present display device, a cooling plate (100) having a refrigerant inside is provided at the rear of the backlight (49). Cooling is achieved by phase changes occurring in the refrigerant: evaporation (thus absorbing heat) inside the cooling plate nearest to the heat source, diffusion to a cooler location followed by recondensation (thus releasing heat) inside the cooling plate furthest away from the display panel. Inside the cooling plate, further plates having a mesh stucture (120) and a wick-like structure (130) are arranged to facilitate the circulation of the refrigerant.

## Description

### BACKGROUND

### 1. Field

Exemplary embodiments relate to a display device, and more particularly, a display device capable of enhancing heat-radiating performance.

### 2. Description of the Related Art

A display device, such as a television, a monitor for a computer, and a digital information display, is configured to display images on a screen. Recently, a use of the display device being installed outdoors, for example, for advertisement has been increased. A billboard to display images while disposed at an outside of a building is included in the above.

The outdoor display device may have an increased surface temperature of a display panel when the display panel is directly exposed to solar ray, and thus deterioration phenomenon by heat may occur. In addition, the display device includes the display panel (hereinafter referred to as a liquid crystal panel), and a backlight unit to radiate light to a bottom surface of the liquid crystal panel. The liquid crystal panel is formed in a pair of boards facing each other while having a liquid crystal layer disposed therebetween. The backlight unit is provided with a light source to radiate light at the liquid crystal panel, and as for the light source, a cold cathode fluorescent tube or a light-emitting diode is being used. The light source of the backlight unit may generate light, as well as heat, and thus the liquid crystal may be deteriorated due to the heat.

Therefore, the display device is provided with a cooling apparatus configured to release the generated heat. The cooling apparatus is provided with a structure having a fan and an air filter, and is configured to inlet outside air by use of the fan and form a cooling path to cool a front surface of the liquid crystal panel at the same time, while provided to absorb and exhaust solar heat and the heat of the liquid crystal panel through the cooling path.

With respect to a heat radiating apparatus having the fan and the air filter as such, the air filter is periodically needed to be replaced, and such has been resulted in high cost of maintenance and repair.

In addition, as the fan and the air filter are needed to be disposed together, the thickness of a product is needed to be thick as much as the thickness of the fan and the air filter, and thereby the aesthetic beauty is lessened.

### SUMMARY

Exemplary embodiments may address at least the above problems and/or disadvantages and other disadvantages not described above. Also, the exemplary embodiments are not required to overcome the disadvantages described above, and may not overcome any of the problems described above. One or more exemplary embodiments provide a display device capable of enhancing heat-radiating performance.

One or more exemplary embodiments provide a display device capable of enhancing cooling performance by use of a sheet direction heat-transferring structure.

One or more exemplary embodiments provide a display device capable of enhancing aesthetic beauty by slimming of a product.

Additional aspects of the disclosure will be set forth in part in the description which follows and, in part, will be obvious from the description, or may be learned by practice of the disclosure.

In accordance with an aspect of an exemplary embodiment, a display device includes a display panel forming images; a light guide plate to deliver light to the display panel; a light source provided as to radiate light at at least one of side surfaces of the light guide plate; and a cooling plate positioned at a rear of the display panel and provided as to heat-transfer through a phase change of refrigerant provided at an inside of the cooling plate.

The display device may further include a top chassis positioned at a front of the display panel, and allowing the display panel to be exposed therethrough, and the cooling plate may be provided as to make contact with a portion of the top chassis.

The cooling plate may include a first plate provided to form an exterior surface of the cooling plate, a second plate provided in the shape of a mesh at an inside of the first plate, and a third plate provided in the shape of a wick as to make contact with the second plate.

The first plate may include stainless steel.

The second plate may include a plurality of meshes formed with holes having sizes different from each other.

The second plate may further include a silica pad.

The first plate may include an installation assembly.

The cooling plate may be provided with a thickness of about 6 mm or less.

The third plate may include one of copper, stainless steel, aluminum, silicon, and silica (SiO2).

The light source may be disposed at at least one of four edges of the light guide plate.

In accordance with an aspect of an exemplary embodiment, a display device includes a display panel at which images are displayed; a light guide plate disposed at a rear of the display panel; a light source provided as to radiate light at at least one of side surfaces of the light guide plate; a top chassis positioned at a front of the display panel, and provided with an opening allowing the display panel to be exposed therethrough; and a cooling plate positioned at a rear of the display panel in contact with a portion of the top chassis, and provided as to accommodate refrigerant that is evaporated while absorbing heat transferred from the light source and is condensed while releasing the heat.

The cooling plate may include first plates provided in a pair to form an exterior surface, a second plate provided in the shape of a mesh at an inside of the first plate, and a third plate provided in the shape of a wick as to make contact with the second plate.

The first plate may include stainless steel.

The second plate may include a plurality of meshes formed with holes having sizes different from each other.

The second plate may further include a silica pad.

The first plate may include an installation assembly on which a printed circuit board is installed.

The cooling plate may be provided with a thickness of about 6 mm or less.

The third plate may include one of copper, stainless steel, aluminum, silicon, and silica.

### BRIEF DESCRIPTION OF THE DRAWINGS

The above and/or other aspects will become more apparent by describing certain exemplary embodiments with reference to the accompanying drawings, in which:
FIG. 1 is a perspective view schematically showing a display device according to an aspect of an exemplary embodiment.
FIG. 2 is an exploded perspective view schematically showing the display device according to an aspect of an exemplary embodiment.
FIG. 3 is a perspective view showing a cooling plate of the display device according to an aspect of an exemplary embodiment.
FIG. 4 is an exploded perspective view of the cooling plate according to an aspect of an exemplary embodiment.
FIG. 5 is a drawing schematically showing an inside structure of the cooling plate according to an aspect of an exemplary embodiment.
FIG. 6 is a cross-sectional view of an A-A' portion of FIG. 1.
FIG. 7 is a drawing showing an installation assembly of the cooling plate according to an aspect of an exemplary embodiment.
FIG. 8 is drawing showing a display device at which a cooling plate is installed according to an aspect of an exemplary embodiment.

### DETAILED DESCRIPTION

Certain exemplary embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the exemplary embodiments. However, it is apparent that the exemplary embodiments can be practiced without those specifically defined matters. Also, well-known functions or constructions are not described in detail since they would obscure the description with unnecessary detail.

The present disclosure may be applied to any electronic product configured such that heat may be transferred or radiated in a sheet direction in an apparatus generating the heat due to a heat source.

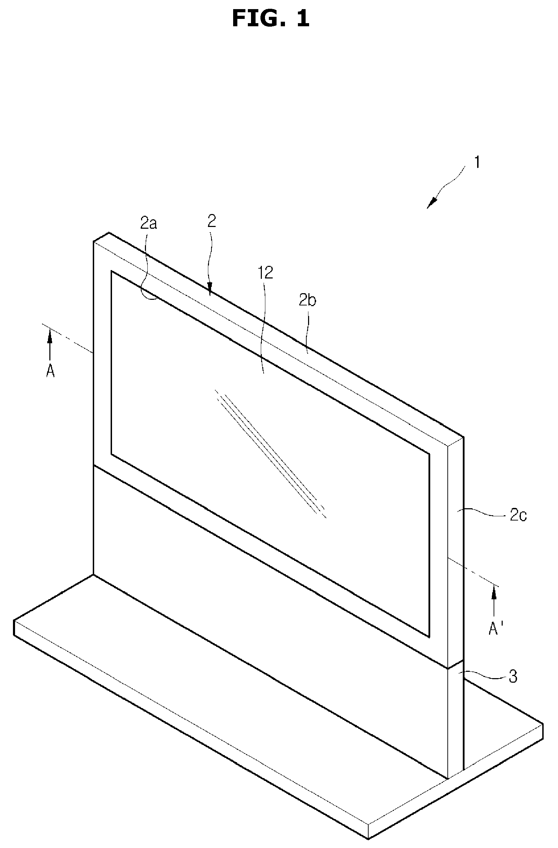

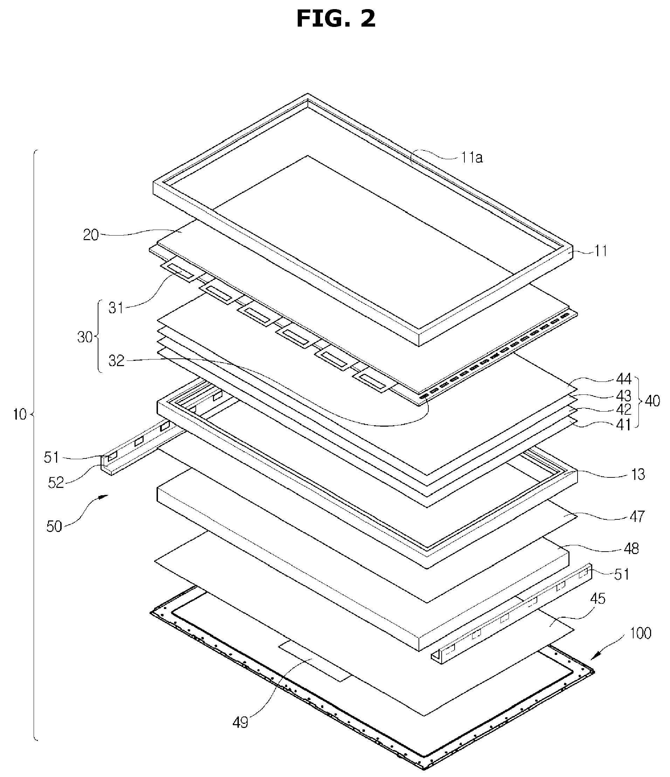

FIG. 1 is a perspective view schematically showing a display device according to an aspect of an exemplary embodiment, and FIG. 2 is an exploded perspective view schematically showing the display device according to an aspect of an exemplary embodiment.

A display device is an apparatus capable of processing image signals being received from an outside, and visually displaying the processed images. Hereinafter, a case of the display device as an outdoor display device being installed outdoors is described as an example, but is not limited hereto. For example, the display device may be implemented as a monitor, a mobile multimedia apparatus, or a mobile communication apparatus, and the shape of the display device is not limited as long as the display apparatus is configured to visually display images.

As illustrated in FIG. 1 and FIG. 2, the display device 1 includes a case 2 forming an exterior appearance and provided with an opening 2a formed at a front thereof, a glass 12 provided at the opening 2a of the case 2, and a display module 10 provided at an inside of the case 2 as to have images displayed.

The case 2 is provided as to be installed at outdoors. The case 2 is provided such that the display module 10 may be installed at an inside thereof. The case 2 includes an upper surface 2b and two side surfaces 2c to form edges.

At least a portion of a front surface of the case 2 may be provided with the opening 2a formed thereto. The opening 2a of the case 2 may be provided with the glass 12 installed thereto. Meanwhile, in the present exemplary embodiment, the front surface of the case 2 is illustrated such that the opening 2a with the glass 12 is included only into a portion of an upper side of the case 2, but the present exemplary embodiment is not limited hereto. For example, the entirety of the front surface may be formed while provided with the opening 2a so that the front surface is entirely formed by the glass.

The glass 12 provided at the opening 2a of the case 2 may be formed by use of transparent material having transparent member provided with adequate strength such as tempered glass.

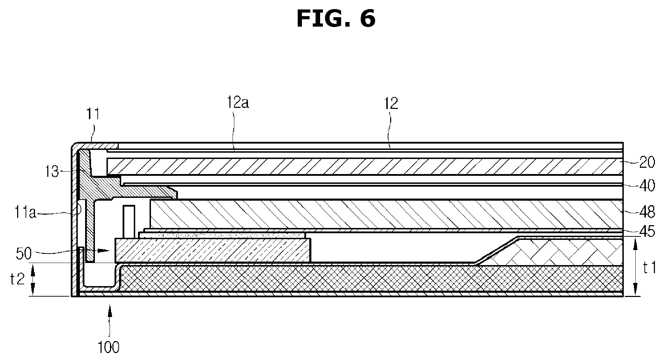

As shown in FIG. 6, an inner surface of the glass 12 may be provided with a film 12a to block reflective light due to outside light. The film 12a may include a polarized film.

The glass 12 may be formed in the size corresponding to the display module 10 provided at an inside of the case 2, and the images being displayed at the display module 10 installed at the inside of the case 2 may be seen from outside.

A lower portion of the case 2 may be provided with a stand 3 to fix and support the display device 1.

The display module 10 at the inside of the case 2 includes a display panel 20, and a backlight unit 50 provided as to radiate light at the display panel 20 while provided at a rear of the display panel 20.

The display module 10 may include a top chassis 11 disposed at a front surface of the display panel 20, and a middle mold 13 provided at an inside of the display module 10 as to support the display panel 20.

The top chassis 11 is formed as a rectangular shape or ring, and is configured to prevent an edge portion of the display panel 20 from being exposed to an outside while provided at an identical surface at which the display panel 20 is provided.

The middle mold 13 is provided to support the display panel 20, an optical member 40, and the backlight unit 50. The middle mold 13 is provided to support the display panel 20 and the optical member 40.

The display panel 20 may include a liquid crystal layer (not shown), a transparent electrode layer (not shown), a transparent board (not shown), and a color filter array (not shown). A proper amount of liquid crystal is provided at the liquid crystal layer. Both sides of the liquid crystal layer are provided with a pair of the transparent electrode layers to form converting electric field at the liquid crystal layer. The electric field applied to the liquid crystal layer may be changed according to the power being input in between the pair of the transparent electrode layers.

The transparent electrode layers as such may include a gate line (not shown), data line (not shown), and a Thin Film Transistor (TFT).

The pair of transparent boards (not shown) is provided to form an exterior appearance of the display panel 20, and is configured to protect the liquid crystal layer and the transparent electrode layer. The transparent board as such may be structured by use of tempered glass or transparent film having high light penetrability.

The display panel 20 is provided to generate images by blocking or penetrating the light generated from the backlight unit 50, which is to be described below. In detail, each pixel composing the display panel 20 may block or penetrate the light of the backlight unit 50, and the images having a variety of colors may be generated.

A driving circuit 30 is configured to provide driving signals to drive the display panel 20. The driving circuit 30 may include a data driving circuit 31 and a gate driving circuit 32. The gate driving circuit 32 may deliver gate signals to the gate line (not shown) while connected to the gate line of the display panel 20. The data driving circuit 31 may deliver data signals to the data line (not shown) while connected to the data line of the display panel 20.

The backlight unit 50 is installed at a rear of the display panel 20, and is provided to generate light such that the display panel 20 may generate images.

The backlight unit 50 includes a light source 51 provided as to radiate light at the display panel 20, and a light guide plate (LGP) 48.

The optical member 40 is provided to refract or scatter light as to widen the viewing angle of the display device 1 and increase the brightness of the display device 1.

The optical member 40 may include various sheets. For example, the optical member 40 may include a diffusion sheet 41, a prism sheet 42, a protective sheet 43, and a double brightness enhance film (DBEF) 44.

The diffusion sheet 41 is provided to diffuse the light released from the backlight unit 50 along the surface of the display device 1, so that the color and brightness may be evenly seen on the entire screen of the display device 1.

The diffusion sheet 41 is provided to diffuse the light released from the light guide plate 48 in a perpendicular direction with respect to the direction of the light released from the light guide plate 48. In other words, the diffusion sheet 41 is provided to evenly maintain the brightness of the entire surface by diffusing the light released from the backlight unit 50.

The light passed through the diffusion sheet 41 is diffused in a perpendicular direction with respect to the surface of the diffusion sheet 41, and thus the brightness is rapidly decreased. The prism sheet 42 is provided to increase the brightness by bending or collecting the light diffused by use of the diffusion sheet 41.

The prism sheet 42 includes a prism pattern in the shape of a triangular prism, and the prism pattern as such is provided in a plurality of units while adjacently arranged with respect to each other to form the shape of a plurality of bands. That is, the prism pattern protrudes facing the display panel 10 while being formed by the repeated pattern of mountains and valleys.

The protective sheet 43 is provided to protect various components included in the backlight unit 50 from outside impact or introduction of foreign substance. Particularly, the prism sheet 42 may be easily scratched, and the protective sheet 43 may prevent scratches of the prism sheet 42.

The double brightness enhance film 44, as a type of a polarized film, is referred to as a reflective polarized film. The double brightness enhance film 44 as such is provided to penetrate the polarized light, which is in a parallel direction with respect to the polarizing direction of the double brightness enhance film 44, among the light released from the backlight unit 50, and reflect the polarized light, which is in a different direction with respect to the polarizing direction of the double brightness enhance film 44.

The light source 51 is provided at each of the left and right sides of the light guide plate 48 as to output light toward the light guide plate 48. The light source 51 may employ a light emitting diode (LED) or a cold cathode fluorescence lamp (CCFL).

The light source 51 may be provided at an edge portion of the display panel 20 while coupled to a printed circuit board 52 formed by use of flexible material.

The light guide plate 48 provided with the edge-type backlight unit 50 is configured to release light toward a front surface by changing the moving direction of the light being incident from a side surface. A plurality of convex line patterns at the front surface of the light guide plate 48 as to change the moving direction of the light, and a plurality of dots may be formed at a rear surface of the light guide plat 48.

The display device 1 may be provided with at least one circuit board 49 provided to drive the display module 10 by applying signals to the display panel 20. The circuit board 49 may be provided with various means of control such as a CPU and SMP to perform functions while reciprocally exchanging information, and heat is generated from the various means of control as such as heat-generating bodies.

The display module 10 may be heat-deteriorated by the heat generated from an inside components such as the light source and the various control means, as well as by the heat due to the solar ray.

The display module 10 may be heat-deteriorated by the heat generated due to the plurality of light emitting diodes (LEDs) employed as the light source 51 of the backlight unit 50. The heat deterioration as such may reduce the life of the display device 1.

Therefore, in the present exemplary embodiment, the display device 1 provided with the display module 10 includes a cooling plate 100 provided as to maintain the temperature of an inside of the device 1 in a predetermined range.

The cooling plate 100 may be provided to form a rear surface of the display module 10 from a rear of the display module 10.

The cooling plate 100 may make contact with and coupled to at least a portion of the top chassis 11 and/or to the middle mold 13 via an installation assembly 150, which is to be described later, formed at the cooling plate 100.

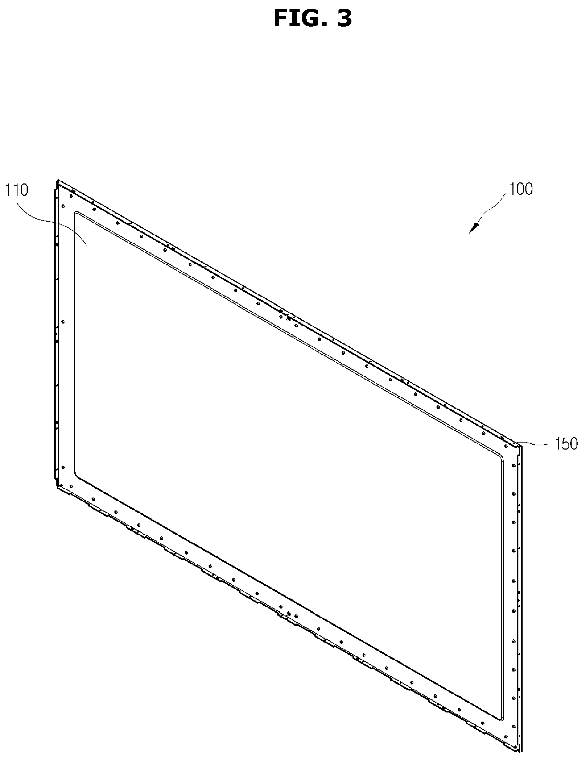

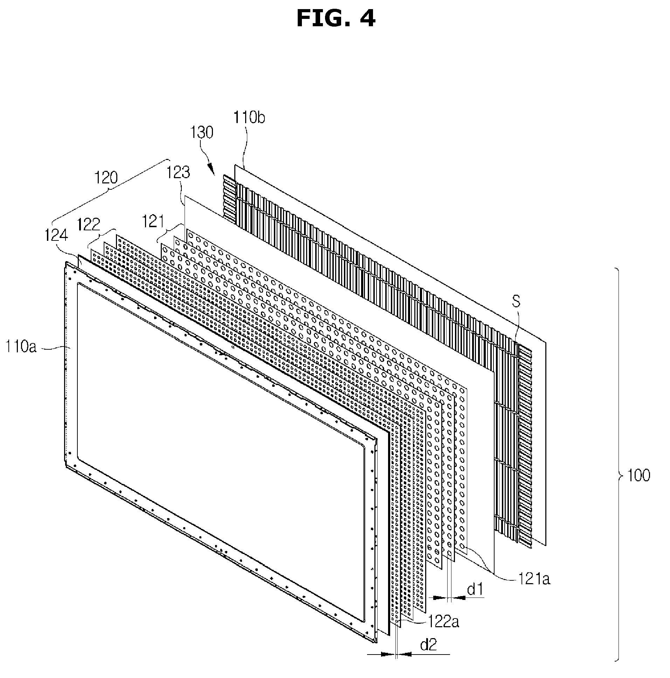

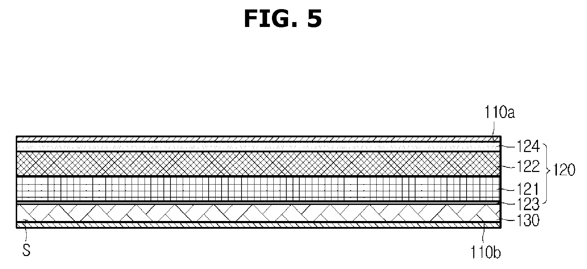

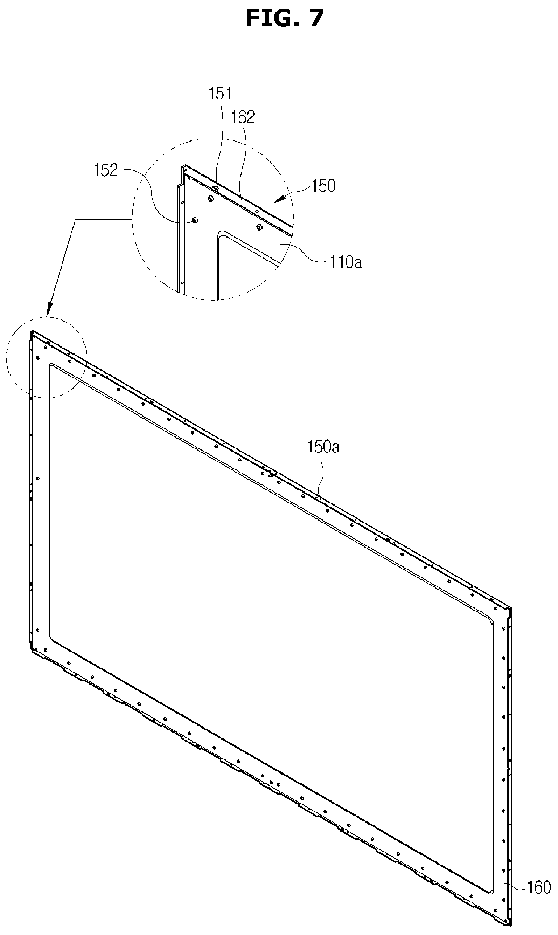

FIG. 3 is a perspective view showing the cooling plate of the display device according to an aspect of an exemplary embodiment, FIG. 4 is an exploded perspective view of the cooling plate according to an aspect of an exemplary embodiment, FIG. 5 is a drawing schematically showing an inside structure of the cooling plate according to an aspect of an exemplary embodiment, FIG. 6 is a cross-sectional view of an A-A' portion of FIG. 1, and FIG. 7 is a drawing showing the installation assembly of the cooling plate according to an aspect of an exemplary embodiment.

As illustrated in FIG. 3 to FIG. 5, the cooling plate 100 may be formed in the shape of a panel. The cooling plate 100 in the shape of a panel may be disposed at a rear of the display module 10. The cooling plate 100 is provided as to form a rear surface of the display module 10.

The cooling plate 100 is formed in the shape and size corresponding to the display panel 20.

The cooling plate 100 is provided as to efficiently scatter and radiate heat of a source of high heat such as the display panel 20 and the backlight unit 50 of the display module 10.

The cooling plate 100 may include a housing formed as a first plate 110 provided to form an exterior surface of the cooling plate 100, a second plate 120 provided at an inside of the first plate 110 and formed as a mesh, and a third plate 130 provided at an inside of the first plate 110 and formed as a wick.

The cooling plate 100 further includes refrigerant (not shown) provided as to be phase-changed at an inside of the cooling plate 100. When the refrigerant is installed as to make contact with a heat source configured to generate heat, the portion of the refrigerant near the heat source is vaporized after being heated, and is diffused to an area in which the temperature is relatively low. Then, the vaporized refrigerant is condensed while releasing heat to an outside to be in a liquid state, and is returned again to an original position.

Thus, the heat generated from the heat source by use of a circulating mechanism of the refrigerant taken place at an inside of the cooling plate 100 is released to an outside, and accordingly, the temperature of the display module 10 may be maintained at an adequate level.

The first plate 110 of the cooling plate 100 is formed from stainless steel (SUS). The stainless steel material is configured to secure strength and evenness in a case when the cooling plate 100 is provided in large size.

The first plate 110 is disposed at a rear of the display panel 20 and the backlight unit 50. The first plate 110 may form a rear surface of the display module 10.

The first plate 110 may be provided in two units formed as a pair of plates by a front plate 110a and a rear plate 110b. The front plate 110a and the rear plate 110b of the first plate 110 are provided while coupled to each other, to form the housing of the cooling plate 100.

An inside of the first plate 110 may be provided with the second plate 120 in the shape of a mesh and the third plate 130 in the shape of a wick stacked on top of each other.

The second plate 120 includes a plurality of meshes 121, 122, and 123 formed as holes 121a and 122a having different sizes with respect to each other.

The meshes 121, 122, and 123 includes a first mesh 121 formed as the hole 121a having a first diameter d1, a second mesh 122 formed as the hole 122a having a second diameter d2, and a third mesh 123 formed as a micro hole (not shown).

The holes of each of the first mesh 121, the second mesh 122, and the third mesh 123 are formed as a plurality of holes.

The second diameter d2 of the second mesh 122 may be formed to be smaller than the first diameter d1 of the first mesh 121, and the diameter of the hole of the third mesh 123 may be formed to be smaller than the second diameter d2 of the second mesh 122.

Therefore, the plurality of meshes 121, 122, and 123 are formed as the holes 121a and 122a having different diameters with respect to each other, that are stacked on top of each other.

The stacking structure of the meshes 121, 122, and 123 as such may be formed as to maintain strength and provided as path for vapor.

The second plate 120 may further include a silica pad 124. The silica pad 124 may be provided as to retain refrigerant at an inside of the cooling plate 100.

Meanwhile, an edge of the cooling plate 100 may be formed such that silica pile may be filled as to easily supply refrigerant.

The third plate 130 is formed as to efficiently circulate refrigerant while provided in a wick structure. The third plate 130 is provided to retain refrigerant, and the refrigerant is vaporized by use of heat, diffused in various directions through an inside space S, and then released and condensed.

As illustrated in FIG. 6, the cooling plate 100 may be provided with a thickness thereof formed differently depending on the position of the heat source.

The cooling plate 100 may be formed having a first thickness t1 by having the first plate 110, the second plate 120, and the third plate 130.

The cooling plate 100 may be formed with a second thickness t2 by having the first plate 110 and the second plate 120.

The first thickness t1 may be formed to be thicker than the second thickness t2 by the thickness of the third plate 130.

The cooling plate 100 may be provided such that various thicknesses may be formed according to the position of the heat source and design. For example, the cooling plate 100 may be provided with a central portion thereof formed with the first thickness t1, and the outer edges thereof formed with the second thickness t2.

The cooling plate 100 of the present exemplary embodiment may be formed with the stainless steel material, and thereby the strength and evenness may be enhanced.

As shown in FIG. 7, the cooling plate 100 may be provided with the installation assembly 150 formed on the front plate 110a such that a separate member such as the circuit board 49 or the printed circuit board 52 may be installed and affixed to the cooling plate 100. The installation assembly 150 may be formed integrally with the cooling plate 100 of the same material, for example, of the stainless steel material.

The installation assembly 150 may include an installation frame 150a having outer edge 160 extending along the perimeter of the front plate 110a, the bent edge or edges 162 that are bent from the outer edge to extend in a direction of the display panel 20, an installation hole or holes 151 which penetrate the installation frame 150a, and an installation member or members such as a groove or a protrusion 152 formed at an outer surface portion, i.e., upper surface, of the front plate 110a.

For example, the installation hole 151 may be fastened via a corresponding protrusion on an inner side 11a of a side surface of the top chassis 11 so that the cooling plate 100 may be assembled by making contact of an installation assembly 150 with the top chassis 11.

The installation assembly 150 as such is provided such that the circuit board 49 or the printed circuit board 52 provided at an inside of the display module 10 may be installed. For example, the installation hole 151 formed at the installation frame 150a of the installation assembly 150 may be provided to be coupled to the case 2 forming an exterior appearance of the display device 1.

In addition, the installation assembly 150 of the cooling plate 100 may be coupled to the middle mold 13 through a fastening member (not shown) such as a bolt so that the cooling plate 100 may be coupled to the middle mold 13.

The installation assembly 150 in the present exemplary embodiment is illustrated as an example to be integrally formed with the cooling plate 100, but an exemplary embodiment is not limited hereto. For example, the installation assembly of the cooling plate may be formed through a process such as welding.

The manufacturing method of the cooling plate 100 having the structure as described above is provided to press-process stainless steel-material panel as to form the first plate 110. The upper portion is processed through drawing or trimming, the lower portion is processed through blanking, and a side bar is processed through piercing and notching.

The panel having the stainless steel material is washed through a tunnel-type washing process. The washing product may include a TC alternative solvent.

The panel having the stainless steel material after the washing is completed is provided to form the first plate 110 after a two-step stud welding and a PEM NUT welding are subsequently performed.

An inside of the first plate 110 is provided with a core stacked therein, and the stud welding and a frame welding are performed.

The first plate 110 is vacuum-processed. The degree of vacuum is set in the range between about 10-2 and about 10-3 torr.

The cooling plate 100 having completed with the vacuuming is performed through a heat distribution test, and a second heat distribution test is performed after about 2 to 3 days of aging as to be packed and stacked.

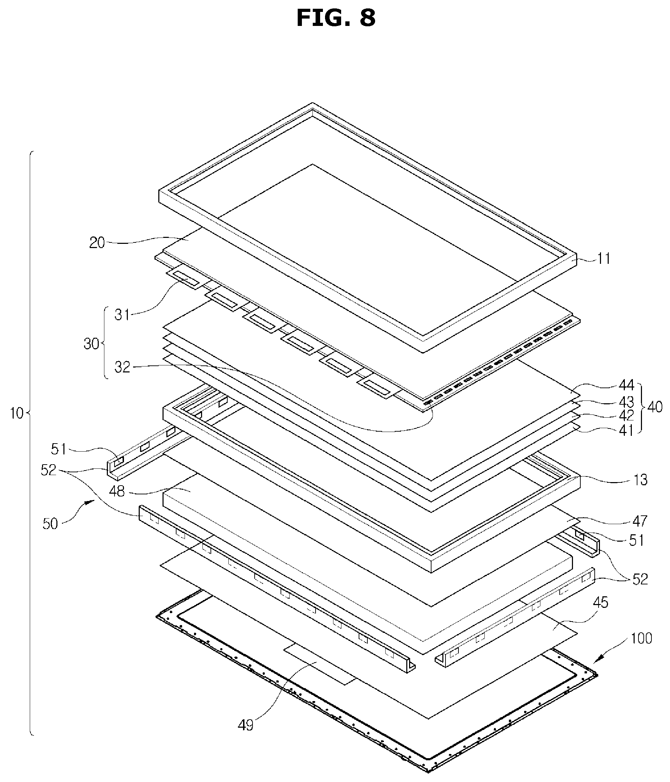

FIG. 8 is drawing showing a display device at which the cooling plate is installed according to an aspect of an exemplary embodiment.

As illustrated in FIG. 8, the display module 10 according to an exemplary embodiment includes the display panel 20, and the backlight unit 50 provided to radiate light at the display panel 20 while provided at a rear of the display panel 20.

The backlight unit 50 is installed at a rear of the display panel 20, and is provided to generate the light such that the display panel 20 may generate images.

The backlight unit 50 includes the light source 51 provided as to radiate light at the display panel 20, the light guide plate 48 to convert the light generates at the light source 51 into sheet light, a reflector sheet 45 to reflect the light being output from the light guide plate 48 while provided at a rear surface of the light guide plate 48, and a quantum dot sheet 47 to output white light, that is, the light mixed with lights having various colors, by receiving the light from the light guide plate 48.

The light source 51 is provided at four edges of the light guide plate 48.

The light source 51 is provided at four edge portions of the display panel 20.

The display device 1 is provided with the at least one circuit board 49 provided as to drive the display module 10 by applying signals to the display panel 20. The circuit board 49 may be provided with various means of control such as a CPU and SMP mounted thereto as to perform functions while reciprocally exchanging information, and heat is generated from the various means of control as such as heat-generating bodies.

The display module 10 may be heat-deteriorated by the heat generated from an inside due to the light source as such and the various means of control, as well as by the heat due to solar ray.

Therefore the display device 1 may be provided with the cooling plate 100 provided as to maintain the temperature of an inside of the device 1 in a predetermined range. The cooling plate 100 may be provided to form a rear surface of the display module 10 from a rear of the display module 10.

The cooling plate 100 may increase cooling efficiency as the cooling plate 100 may absorb and radiate high heat through heat conduction through a large area. The structure of the cooling plate 100 in detail is identical to the above one embodiment, and thus the overlapping descriptions will be omitted.

As is apparent from the above, the display device in accordance with an aspect of an exemplary embodiment is provided with an effect to enhance heat-radiating performance by using a sheet direction heat-transferring structure.

In addition, an effect of enhancing pleasant aesthetic appearance and user's convenience by slimming of a product may be present.

In addition, without having to be provided with an air filter, the cost of maintenance and repair may be accordingly reduced.

Although a few exemplary embodiments have been shown and described, it would be appreciated by those skilled in the art that changes may be made in the exemplary embodiments without departing from the principles and spirit of the disclosure, the scope of which is defined in the claims and their equivalents.

## Claims

1. A display device, comprising:
a display panel forming images;
a light guide plate to deliver light to the display panel;
a light source configured to radiate light and provided at at least one of side surfaces of the light guide plate; and
a cooling plate positioned at a rear side of the display panel to provide a heat-transfer through a phase change of refrigerant provided at an inside of the cooling plate.

2. The display device of claim 1, further comprising:
a top chassis which is positioned at a front side of the display panel, and through which the display panel is exposed,
wherein the cooling plate is provided to make contact with a portion of the top chassis.

3. The display device of claim 1, wherein:
the cooling plate comprises a first plate provided to form an exterior surface of the cooling plate,
a second plate provided in the shape of a mesh at an inside of the first plate, and
a third plate provided in the shape of a wick to make contact with the second plate.

4. The display device of claim 3, wherein:
the first plate comprises stainless steel (SUS).

5. The display device of claim 3, wherein:
the second plate comprises a plurality of meshes formed with holes having sizes different from each other.

6. The display device of claim 3, wherein:
the second plate further comprises a silica pad.

7. The display device of claim 3, wherein:
the first plate comprises an installation unit.

8. The display device of claim 1, wherein:
the cooling plate has a thickness of about 6mm or less.

9. The display device of claim 3, wherein:
the third plate comprises one of copper, stainless steel, aluminum, silicon, and silica (SiO₂).

10. The display device of claim 1, wherein:
the light source is disposed at at least one of four edges of the light guide plate.
